# EUROPÄISCHE PATENTSCHRIFT

(11) **EP 3 292 742 B1**
(45) Veröffentlichungstag und Bekanntmachung des Hinweises auf die Patenterteilung: **10.05.2023**
(21) Anmeldenummer: 16720997.2
(22) Anmeldetag: 22.04.2016
(51) Int. Cl.: H05K 1/02, H05K 13/08, H05K 3/30, F21S 41/141, F21S 41/19

(54) **VERFAHREN ZUR POSITIONIERUNG ZUMINDEST EINER ELEKTRONISCHEN KOMPONENTE AUF EINER LEITERPLATTE**
METHOD FOR POSITIONING AT LEAST ONE ELECTRONIC COMPONENT ON A CIRCUIT BOARD
PROCÉDÉ DE POSITIONNEMENT D'AU MOINS UN COMPOSANT ÉLECTRONIQUE SUR UNE CARTE DE CIRCUITS IMPRIMÉS

(30) Priorität: 04.05.2015 AT 503572015
(43) Veröffentlichungstag der Anmeldung: 14.03.2018
(73) Patentinhaber: ZKW Group GmbH, 3250 Wieselburg (AT)
(72) Erfinder: KIESLINGER, Dietmar, 2604 Theresienfeld (AT); WURM, Peter, 7000 Eisenstadt (AT); IDRIZAJ, Arianit, 7013 Klingenbach (AT)
(74) Vertreter: Patentanwaltskanzlei Matschnig & Forsthuber OG
(86) Internationale Anmeldenummer: PCT/AT2016/050109
(87) Internationale Veröffentlichungsnummer: WO 2016/176702

(56) Entgegenhaltungen:
- EP-A1- 1 691 592
- EP-A1- 2 983 458
- WO-A1-2014/153576
- US-A1- 2006 016 069
- US-A1- 2012 098 020

## Beschreibung

Die Erfindung betrifft ein Verfahren zur Positionierung zumindest einer elektronischen Komponente auf einer Leiterplatte zum Einbau in einen Fahrzeugscheinwerfer, bei welchem die Positionierung der zumindest einen elektronischen Komponente relativ zu zumindest einer Positionsmarke auf der Leiterplatte erfolgt, wobei die zumindest eine Positionsmarke optisch erfasst wird.

Fahrzeugscheinwerfer umfassen im zunehmenden Maße elektronische und insbesondere Halbleiterbauelemente, wobei vor allem die LED-Technik, bei der lichtemittierende Dioden (LED) als Lichtquelle für den Scheinwerfer Verwendung finden, in großem Umfang eingesetzt wird. LEDs weisen eine hohe Lichtausbeute auf und zeichnen sich durch einen geringen Platzbedarf gegenüber herkömmlichen Lichtquellen wie Halogenlampen aus. Die LEDs sind in aller Regel auf Leiterplatten bzw. Platinen, die auch entsprechende Leiterzüge zur Stromversorgung der LEDs aufweisen, festgelegt und werden mit im Leiterplattenbau bekannten Bestückungsverfahren auf den Leiterplatten festgelegt.

Bei der Verwendung von LEDs als Lichtquellen für Fahrzeugscheinwerfer sind überaus geringe Toleranzen hinsichtlich der Positionierung der LEDs bezüglich der den LEDs zugeordneten optischen Bauteile wie Reflektoren und/oder Linsen einzuhalten, da der Gesetzgeber für die überaus leuchtstarken LEDs genaue Vorgaben hinsichtlich des erzielten Lichtbilds vorschreibt, um eine Blendung des Gegenverkehrs beim Betrieb des Fahrzeugscheinwerfers zu vermeiden. Im Stand der Technik ist es daher aufgrund der Fertigungsungenauigkeiten, die in der herkömmlichen Leiterplattenbautechnik regelmäßig auftreten, notwendig, Bauteile wie Reflektoren und/oder Linsen je nach der tatsächlichen Position der LEDs bzw. der Lichtquellen auf der Leiterplatte bzw. Platine einzustellen. Die Toleranzen, die beim Bestücken von LEDs und ähnlichen Lichtquellen wie beispielsweise Laserdioden, auftreten, führen daher beim Scheinwerferhersteller zu der Notwendigkeit, die erforderliche relative Position von Reflektoren und/oder Linsen, empirisch zu bestimmen und die optischen Elemente in dieser bestimmten Position festzulegen. Während die Herstellung von Leiterplatten ein weitgehend automatisierter Prozess ist und daher schnell und in hoher Stückzahl und somit überaus kostengünstig erfolgen kann, bedeutet die Einstellung eines Scheinwerfers hinsichtlich der relativen Position von Lichtquellen und optischen Elementen wie Reflektoren und/oder Linsen einen hohen Arbeitsaufwand, der dem Erfordernis einer effizienten und kostengünstigen Scheinwerferproduktion entgegensteht.

Eine bedeutende Ursache für die relative Ungenauigkeit der Positionierung von Lichtquellen auf einer Leiterplatte oder Platine zur Verwendung in einem Fahrzeugscheinwerfer beruht vor allem darauf, dass auch bei überaus genauer Fertigung der Platine hinsichtlich der Leiterzüge und der Position der Lichtquellen, die Anfertigung von Befestigungsmöglichkeiten für die Leiterplatte am Fahrzeugscheinwerfer, in aller Regel Randabschnitte beziehungsweise Ausrichtmarken der Leiterplatte wie Ränder, Kerben und/oder Bohrungen nicht mit derselben Präzision durchführbar ist wie die Anfertigung von Leiterzügen und Kontaktpads für Lichtquellen wie LEDs oder Laserdioden. Bei herkömmlichen Referenziermöglichkeiten für Lichtquellen und Befestigungsmöglichkeiten, die sich an Positionsmarken orientieren, die ähnlich wie die Leiterzüge auf eine Leiterplatte aufgebracht oder die auf eine Leiterplatte aufgeätzt oder aufgedruckt werden, pflanzen sich Fehler beim Setzen der Befestigungsmöglichkeiten einerseits und bei der Montage der Lichtquellen andererseits fort. Solche Referenziermöglichkeiten können daher nicht zu den gewünschten präzisen Ergebnissen führen, da aufgrund der besagten Ungenauigkeit der Position der Befestigungsstrukturen der Leiterplatte eine intrinsische Ungenauigkeit beim Festlegen am Fahrzeugscheinwerfer resultiert, die wiederum dazu führt, dass optische Elemente wie Reflektoren und/oder Linsen nachträglich zur Erzielung des gewünschten Lichtbilds eingestellt werden müssen.

Die WO 2014/153576 A1 zeigt ein Verfahren zur Herstellung eines bestückten Schaltungsträgers. Aus der US 2012/098020 A1 ist ein Keramiksubstrat zur Anbringung von Leuchtdioden bekannt. Die US 2006/016069 A1 offenbart eine Steckverbindungsanordnung zur Verwendung in einer Schnittstelle zwischen einem Gerät und einem Kabel.

Die Erfindung zielt daher darauf ab, die geschilderten Unzulänglichkeiten zu eliminieren und ein Verfahren der eingangs genannten Art dahingehend zu verbessern, dass ein nachträgliches Positionieren bzw. Einrichten von optischen Elementen wie Reflektoren und/oder Linsen nach dem Bestücken und Festlegen einer Leiterplatte in einem Fahrzeugscheinwerfer entfallen kann, sodass eine möglichst vollständig automatisierte Produktion von Fahrzeugscheinwerfern möglich wird.

Zur Lösung dieser Aufgabe ist ein Verfahren gemäß der eingangs genannten Art erfindungsgemäß dahingehend weitergebildet, dass die als zumindest eine Positionsmarke zumindest eine Ausrichtmarke der Leiterplatte verwendet wird, welche in dem Fahrzeugscheinwerfer im eingebauten Zustand der Leiterplatte mit einem komplementären Positionierungsmittel des Fahrzeugscheinwerfers mechanisch zusammenwirkt. Wie bereits erwähnt, dienen insbesondere Ausrichtmarken der Leiterplatte der mechanischen Positionierung bzw. Festlegung der Leiterplatte am Fahrzeugscheinwerfer. Als Ausrichtmarken eignen sich insbesondere Ausnehmungen in der Leiterplatte, die in Randabschnitten, das heißt an Kanten oder Rändern, die die Leiterplatte begrenzen, gelegen sind und dabei mechanische Markierungen beispielsweise in Form von Kerben umfassen können. Ebenso geeignet sind beispielsweise Bohrungen, durch die eine begrenzende Kante oder Rand verlaufen kann. Auch Bohrungen, die zur Gänze innerhalb der Leiterplatte gelegen sind, sind prinzipiell als Ausrichtmarken geeignet. Mechanische Positionierungsmittel können in Form von Zapfen, Anschlägen und Ähnlichem gebildet sein, die auf entsprechenden Bauteilen eines Fahrzeugscheinwerfers vorgesehen sind, um mit entsprechend geformten Ausrichtmarken der Leiterplatte zur Definition einer Orientierung und Position der Leiterplatte am bzw. im Fahrzeugscheinwerfer zusammenzuwirken. Wenn nun erfindungsgemäß eine solche für das Zusammenwirken mit mechanischen Positionierungsmitteln vorgesehene Ausrichtmarke der Leiterplatte als Positionsmarke herangezogen wird, die erfasst wird, um die Positionierung einer elektronischen Komponente relativ zu dieser Positionsmarke zu bewerkstelligen, so wird in der Produktion des Fahrzeugscheinwerfers eine wesentliche Quelle für Ungenauigkeiten ausgeschaltet, da die zumindest eine elektronische Komponente, beispielsweise eine LED (light emitting diode) zu einer Ausrichtmarke referenziert wird, die in der Einbausituation der Leiterplatte, die diese elektronische Komponente trägt, die tatsächliche Position im Fahrzeugscheinwerfer und damit relativ zu weiteren optischen Elementen wie Reflektoren und/oder Linsen bestimmt, die für das resultierende Lichtbild des Fahrzeugscheinwerfers mit der elektronischen Komponente zusammenwirken,. Insgesamt wird durch die Anwendung des erfindungsgemäßen Verfahrens eine mögliche Fehlerquelle hinsichtlich der Positionierung von elektronischen Komponenten ausgeschaltet, sodass insgesamt eine höhere Präzision erreicht wird, und insbesondere der Aufwand zur nachträglichen Ausrichtung von optischen Bauelementen vermieden werden kann.

Da zur Positionierung von elektronischen Komponenten auf der Leiterplatte das Zusammenwirken mit Positionierungsmitteln eines Fahrzeugscheinwerfers wesentlich ist, ist klar, dass die Leiterplatte besonders gut mit den Positionierungsmitteln zusammenwirken kann, das heißt in einem Fahrzeugscheinwerfer besonders fest und präzise montiert werden kann, um beispielsweise gegen Verdrehungen gesichert zu sein, wenn zumindest zwei Ausrichtmarken zur Montage und folglich auch zur Positionierung herangezogen werden. Die Leiterplatte kann besonders dadurch präzise festgehalten werden, indem sie an zumindest zwei Orten mit den Positionierungsmitteln als mechanische Verbindung zusammenwirkt. Wenn zumindest zwei Ausrichtmarken zur Positionierung herangezogen werden, können die Ausrichtmarken selbst besonders einfach, beispielsweise als Kerben, gestaltet sein und eine einfache Montage in einem Fahrzeugscheinwerfer erlauben.

Bei Verwendung von nur einer Ausrichtmarke im Zuge der Positionierung ist grundsätzlich auch eine präzise Ausrichtung der Leiterplatte, insbesondere bei kleineren Leiterplatten in Bezug auf eine Einbauposition in einem Fahrzeugscheinwerfer möglich. Bei größeren Leiterplatten ist es vorteilhaft, wenn zumindest zwei Ausrichtmarken zur Positionierung herangezogen werden, um eine größtmögliche Präzision zu erhalten, was insbesondere dadurch erreicht werden kann, wenn zumindest zwei Ausrichtmarken auf der Leiterplatte für das erfindungsgemäße Verfahren herangezogen werden, die auf der Leiterplatte an gegenüberliegen Kanten oder Randbereichen, vorzugsweise an den längsten gegenüberliegenden Rändern oder Kanten der Leiterplatte liegen, falls die Leiterplatte eine im Wesentlichen rechteckige Form aufweist. Eine im Wesentlichen rechteckige Form bedeutet hier, dass durchaus abgerundete Ecken oder andere Formanpassungen der Leiterplatte zum Einbau in einem Fahrzeugscheinwerfer ausgeführt sein können, die der Leiterplatte zugrunde liegende Form aber zum überwiegenden Teil dem Verlauf eines Rechtecks folgt.

Zur konsequenten Umsetzung einer automatisierten Herstellung der erfindungsgemäßen Leiterplatte ist das erfindungsgemäße Verfahren dadurch gekennzeichnet dass die zumindest eine Ausrichtmarke von einer ersten Seite der Leiterplatte insbesondere mit einer Kamera optisch erfasst wird und bevorzugt anhand von Positionsdaten der zumindest einen Ausrichtmarke ein Datensatz mit einer Bestückungsposition für die zumindest eine Komponente erstellt und einer Bestückungsmaschine für elektronische Komponenten zur Verfügung gestellt wird. Solche Kamera gestützte Verfahren zur Erfassung von sichtbaren Strukturen sind im Stand der Technik bekannt und können ohne Weiteres auch auf Ausrichtmarken wie Löcher, Langlöcher, Kanten, Ränder und Kerben einer Leiterplatte angewendet werden, wobei die heutzutage übliche digitale Bilderfassung die Möglichkeit bietet, vollständig automatisiert Datensätze mit einer Bestückungsposition für die zumindest eine Komponente zu erstellen.

Um die optische Erfassung der Ausrichtmarke der Leiterplatte und insbesondere die optische Erfassung mit einer Kamera zu verbessern, ist das erfindungsgemäße Verfahren dahingehend weitergebildet, dass die Leiterplatte von einer zweiten, der ersten Seite gegenüberliegenden Seite beleuchtet wird. Das Beleuchten der Leiterplatte von der zweiten Seite, die der ersten Seite von der aus die Leiterplatte mit einer Kamera optisch erfasst werden kann, gegenüberliegt, führt zu einer deutlichen Erhöhung des Kontrasts an Randbereichen beziehungsweise an den Ausrichtmarken der Leiterplatte, so dass Ausrichtmarken und somit auch Ausrichtmarken, die für das Zusammenwirken mit mechanischen Positionierungsmitteln für die Leiterplatte am Fahrzeugscheinwerfer vorgesehen sind, deutlich besser erkannt werden können.

In aller Regel werden Leiterplatten zur Erzeugung von Rändern und Kanten und somit auch zur Erzeugung von Ausrichtmarken für das Zusammenwirken mit mechanischen Positionierungsmitteln durch Schneiden, Fräsen, Stanzen und/oder Bohren hergestellt, wodurch solche Ausrichtmarken genau betrachtet, keineswegs nahezu ideale glatte Kanten und ebenmäßige Oberflächen, sondern im Gegenteil oft große Unregelmäßigkeiten aufweisen. Da jedoch letzten Endes eben dieser unregelmäßige Verlauf der Ausrichtmarke für die tatsächliche Position der Leiterplatte im Fahrzeugscheinwerfer relevant ist, muss dieser zur Erzielung höchstmöglicher Präzision bei der Positionierung der elektronischen Komponenten gemäß dem erfindungsgemäßen Verfahren möglichst präzise optisch erfasst werden. Das erfindungsgemäße Verfahren ist daher bevorzugt dahingehend weitergebildet, dass das Beleuchten mit parallel gerichtetem Licht erfolgt. Das Beleuchten mit parallel gerichtetem Licht von der zweiten Seite und das Erfassen des parallel gerichteten Lichts am Randabschnitt beziehungsweise an der Ausrichtmarke, insbesondere durch eine Kamera, bildet aufgrund des Fehlens von divergenten Lichtanteilen, die tatsächlich zur Wirkung gelangende Kante der Ausrichtmarke mit größtmöglicher Präzision ab, so dass eine überaus genaue Referenzierung der elektronischen Komponente in Bezug auf die in Einbaulage der Leiterplatte wirksame Ausrichtmarke erfolgen kann. Zudem ist das erfindungsgemäße Verfahren unabhängig von etwaigen Unebenheiten der Oberfläche der ersten Seite der Leiterplatte, während bei der Positionsbestimmung mit mikroskopischen Methoden aufgrund von auslaufenden Schichten von Metall und Lack im Randbereich der Platine die relevante Fokussierebene nicht immer zweifelsfrei bestimmt werden kann.

Für eine weitere verbesserte Positionierung der zumindest einen elektronischen Komponente auf die Leiterplatte wird bevorzugt dergestalt vorgegangen, dass eine Mehrzahl von Positionsmarken einer Leiterplatte erfasst wird. Dem Fachmann wird in diesem Zusammenhang klar sein, dass der Grad der Bestimmung der Positionierung der zumindest einen elektronischen Komponente mit der Anzahl von erfassten Positionsmarken zunimmt, obwohl es unter Umständen durchaus denkbar ist, auch nur eine Positionsmarke zu erfassen und zur Positionierung einer elektronischen Komponente auf einer Leiterplatte heranzuziehen.

Das erfindungsgemäße Verfahren wird insbesondere zur Kostenreduktion bevorzugt dergestalt durchgeführt, dass mehrere Leiterplatten auf einem gemeinsamen Nutzen hergestellt werden und das Erfassen der zumindest einen Positionsmarke erfolgt, wenn die Leiterplatten noch nicht voneinander getrennt sind, was die Umsetzung des erfindungsgemäßen Verfahrens im Rahmen von auf dem Gebiet der Leiterplattentechnik gängigen Produktionsmethoden entspricht. Es ist nämlich in der Leiterplattentechnik üblich, eine Vielzahl von Leiterplatten bzw. Platinen, d.h. von funktionellen Einheiten, die am Ende des Produktionsprozesses als Leiterplatte bzw. Platine angesprochen werden, auf einer gemeinsamen Platte herzustellen. Eine solche Platte, bei der eine Mehrzahl von funktionellen Einheiten miteinander verbunden sind und erst durch spätere Bearbeitungsschritte wie Schneiden, Fräsen oder Stanzen aufgeteilt werden, wird vom Fachmann auf dem betreffenden Gebiet als Nutzen bezeichnet, wobei ein Nutzen nach Herstellung der verschiedenen Leiterzüge und Positionieren bzw. Aufbringen der elektronischen Komponenten, erfindungsgemäß unter Erfassung von für das Zusammenwirken mit mechanischen Positionierungsmitteln vorgesehenen Ausrichtmarken zerschnitten bzw. zerteilt wird, um die funktionellen Einheiten, d.h. die Leiterplatten bzw. Platinen zu erhalten. Das erfindungsgemäße Verfahren gestattet es, eine genaue Positionierung der elektronischen Komponenten bereits vorzunehmen, wenn die Leiterplatten noch zu einem gemeinsamen Nutzen zusammengefasst sind, so dass das erfindungsgemäße Bestücken und Positionieren der elektronischen Komponenten in Maschinen erfolgen kann, die für die Be- und Verarbeitung von großflächigen Nutzen ausgerichtet sind, und üblicherweise beim Leiterplattenherstellungsprozess Verwendung finden.

Besonders vorteilhaft zum Erlangen einer hohen Positionierungspräzision ist es, wenn mehr als eine Leiterplatte auf dem gemeinsamen Nutzen gefertigt ist und die Ausrichtmarken im Nutzen derart angeordnet sind, dass sie bei der Vereinzelung der Leiterplatten, beispielsweise durch Sägen, durchtrennt werden und erst nach dieser Vereinzelung beispielsweise an einer Kante oder einem Rand eine Kerbe oder allgemein eine Einbuchtung ausbilden. Die Einbuchtung kann grundsätzlich jede beliebige Form aufweisen, die dazu geeignet ist, mit den Positionierungsmitteln mechanisch zusammenzuwirken.

Bevorzugt wird hierbei dergestalt vorgegangen, dass jeweils zumindest eine Positionsmarke für jeweils eine Leiterplatte auf dem gemeinsamen Nutzen erfasst wird, so dass die tatsächlich beim Einbau in den Fahrzeugscheinwerfer für die Positionierung der Leiterplatte im Fahrzeugscheinwerfer relevante Positionsmarke bzw. die relevante Ausrichtmarke der Leiterplatte für die exakte Positionierung der zumindest einen elektronischen Komponente herangezogen wird.

Wie bereits oben im Zusammenhang mit dem erfindungsgemäßen Vorgehen bei einer einzelnen Leiterplatte beschrieben, kann auch bei der Bearbeitung von Leiterplatten auf einem gemeinsamen Nutzen dergestalt vorgegangen werden, dass eine Mehrzahl von Positionsmarken für eine zu positionierende Komponente für jeweils eine Leiterplatte auf dem gemeinsamen Nutzen erfasst und zur Erstellung eines Datensatzes mit einer Bestückungsposition für die Komponente herangezogen wird, wie dies einer bevorzugten Ausführungsform der vorliegenden Erfindung entspricht.

Wie ebenfalls bereits weiter oben mehrfach erläutert, wird das erfindungsgemäße Verfahren besonders zweckmäßig zur Herstellung von Fahrzeugscheinwerfern angewendet, sodass das erfindungsgemäße Verfahren bevorzugt dahingehend weitergebildet ist, dass die elektronische Komponente ausgewählt ist aus der Gruppe bestehend aus einer SMD-Komponente, einer LED, einer Laserdiode und einer Photodiode. Eine SMD-Komponente ist dem Fachmann auch als SMD bekannt (SMD = Surface Mounted Device).

Da in einer Produktionsstraße für Leiterplatten üblicherweise die bearbeitenden Werkzeuge auf nur einer Seite der Leiterplatte, die durch die Produktionsstraße läuft, angeordnet sind, wird auch im erfindungsgemäßen Verfahren die optische Erfassung von jener Seite aus durchgeführt, auf der mit den genannten Werkzeugen Leiterzüge und elektronische Komponenten auf die Leiterplatte aufgebracht werden. Dies bedeutet mit anderen Worten, dass das erfindungsgemäße Verfahren bevorzugt dahingehend weitergebildet ist, dass die erste Seite der Leiterplatte jene Seite der Leiterplatte ist, auf der die zumindest eine elektronische Komponente positioniert wird.

Die Erfindung wird nachfolgend anhand eines in der Zeichnung schematisch dargestellten Ausführungsbeispiels näher erläutert. In dieser zeigen
Fig. 1 eine schematische Draufsicht auf eine Leiterplatte mit einer Mehrzahl von elektronischen Komponenten sowie einer Mehrzahl von denkbaren Ausrichtmarken, die als Positionsmarken zur Durchführung des erfindungsgemäßen Verfahrens herangezogen werden können,
Fig. 2 eine schematische Darstellung eines Abschnitts einer Produktionsstraße zur Durchführung des erfindungsgemäßen Verfahrens, sowie
Fig. 3 ein Fließschema des erfindungsgemäßen Verfahrens.

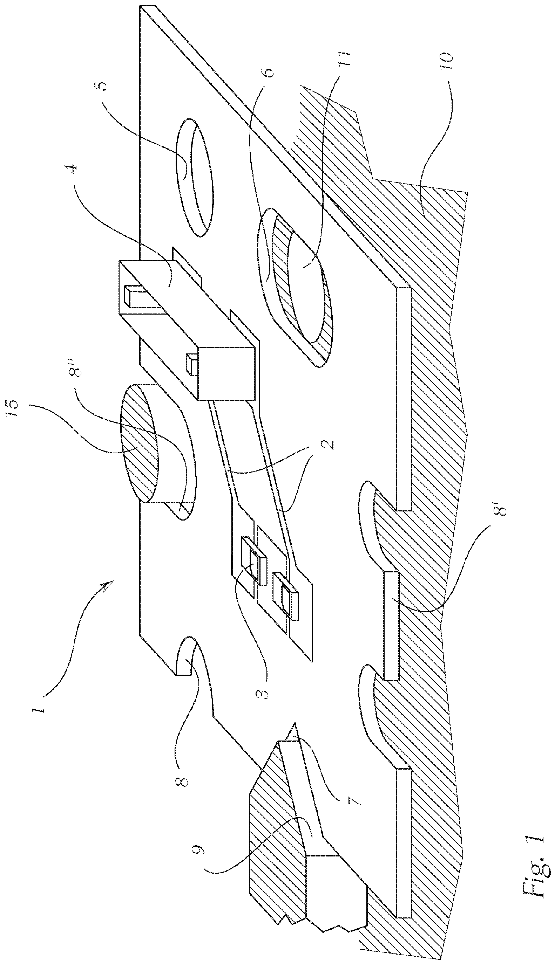

In Fig. 1 ist mit dem Bezugszeichen 1 eine Leiterplatte bezeichnet. Die Leiterplatte 1 weist eine Vielzahl von Leiterbahnen 2 sowie eine Mehrzahl von elektronischen Komponenten 3 auf, wobei die Leiterbahnen 2, die elektronischen Komponenten 3 mit einem Konnektorbereich 4 verbinden, welcher wiederum an eine nicht dargestellte Elektrik eines Fahrzeugs angeschlossen ist. Die Leiterplatte 1 kann nun eine Vielzahl von Positionsmarken aufweisen, wobei die Positionsmarken erfindungsgemäß von einer Ausrichtmarke der Leiterplatte gebildet sind, die zum Zusammenwirken mit mechanischen Positionierungsmitteln für die Leiterplatte am Fahrzeugscheinwerfer vorgesehen ist. Somit können das Loch 5, das Langloch 6, die Kerbe 7 sowie die Einbuchtungen 8, 8', 8" Ausrichtmarken der Leiterplatte bilden. Zur Verdeutlichung der Erfindung sind im Beispiel gemäß der Fig. 1 eine Vielzahl derartiger Ausrichtmarken angegeben. Es ist jedoch offensichtlich, dass zur Realisierung des erfindungsgemäßen Verfahrens weniger oder mehr solcher Ausrichtmarken sowie anders ausgeformte Ausrichtmarken als Positionsmarken herangezogen werden können, solange sie nur bei der Festlegung der Leiterplatte 1 mit entsprechenden mechanischen Positionierungsmitteln für die Leiterplatte am Fahrzeugscheinwerfer zusammenwirken. In Fig. 1 sind beispielhaft ein Zapfen 15 sowie ein Anschlag 9 im Schnitt dargestellt, wobei der Zapfen 15 sowie der Anschlag 9 beispielsweise einstückig mit einem nicht näher dargestellten Kühlkörper 10 eines Fahrzeugscheinwerfers ausgebildet sein können. Alternativ wäre es auch denkbar, dass eine nicht dargestellte Schraube beispielsweise mit dem Loch 5 bzw. dem Langloch 6 zusammenwirkt, wofür im Kühlkörper 10 eine entsprechende Gewindeöffnung 11 vorgesehen ist. Erfindungsgemäß werden nun die Ausrichtmarken des Loches 5, des Langloches 6, der Kerbe 7 und/oder der Einbuchtungen 8, 8', 8" erfasst und die Positionen der einzelnen Komponenten bezüglich dieser Ausrichtmarken definiert.

Im erfindungsgemäßen Verfahren wird zumindest eine elektronische Komponente 3 auf einer zum Einbau in einen Fahrzeugscheinwerfer vorgesehener Leiterplatte 1 positioniert.

Die Leiterplatte 1 umfasst dabei zumindest eine Positionsmarke und die Positionierung der zumindest einen elektronischen Komponente 3 erfolgt relativ zu der zumindest einen Positionsmarke auf der Leiterplatte 1. Die zumindest eine Positionsmarke wird optisch erfasst und zum Positionieren herangezogen.

Als zumindest eine Positionsmarke wird zumindest eine Ausrichtmarke 5, 6, 7, 8, 8', 8" der Leiterplatte 1 verwendet, welche in dem Fahrzeugscheinwerfer im eingebauten Zustand der Leiterplatte 1 mit einer komplementären Ausrichtmarke 9, 15 des Fahrzeugscheinwerfers mechanisch zusammenwirkt.

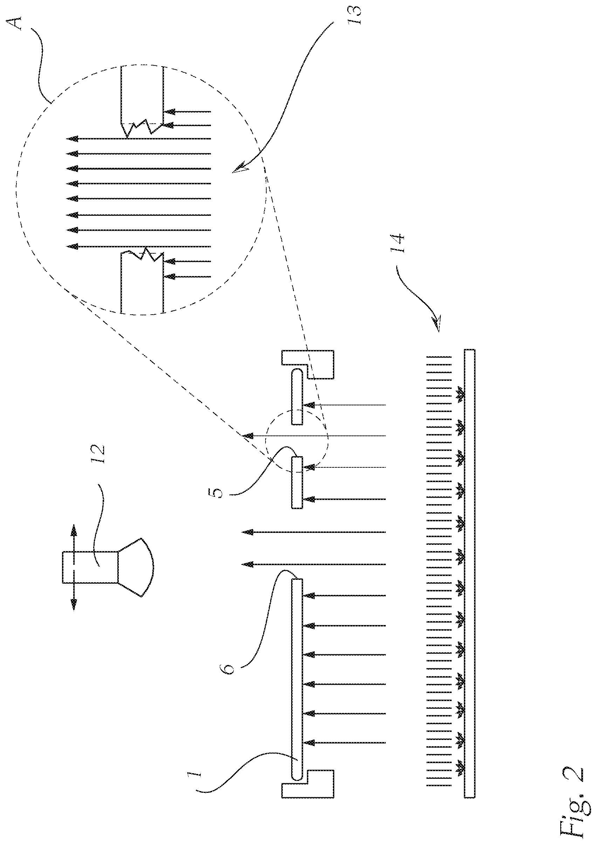

In Fig. 2 ist zur optischen Erfassung beispielsweise die Ausrichtmarke des Loches 5 sowie des Langloches 6 eine Kamera 12 vorgesehen, wobei zur Erhöhung des Kontrastes an den Ausrichtmarken die Leiterplatte 1 von der zweiten Seite, welcher der ersten Seite gegenüberliegt, beleuchtet wird. Das Licht tritt durch die Ausnehmungen, die die Ausrichtmarken bilden, hindurch, so dass die Kamera optimale Kontrastwerte zwischen dem hindurchtretenden Licht und dem durch die Leiterplatte abgeschirmten Licht zur Erfassung der Ausrichtmarken der Leiterplatte zur Verfügung gestellt bekommt.

Im Detail Ader Fig. 2 ist zum einen dargestellt, dass die Ränder bzw. die Ausrichtmarken der Leiterplatte keineswegs ideal verlaufen sondern Ungenauigkeiten, Rauheiten und Ausfransungen aufweisen können, sodass parallel gerichtetes Licht, welches durch die Schar von Pfeilen 13 symbolisiert ist, besonders vorteilhaft eingesetzt werden kann, um den tatsächlich zur Wirkung gelangenden Rand der Ausrichtmarke der Leiterplatte zuverlässig zu erfassen. Das parallel gerichtete Licht wird in einer Produktionsstraße durch den Einsatz eines Kollimators 14 erzeugt.

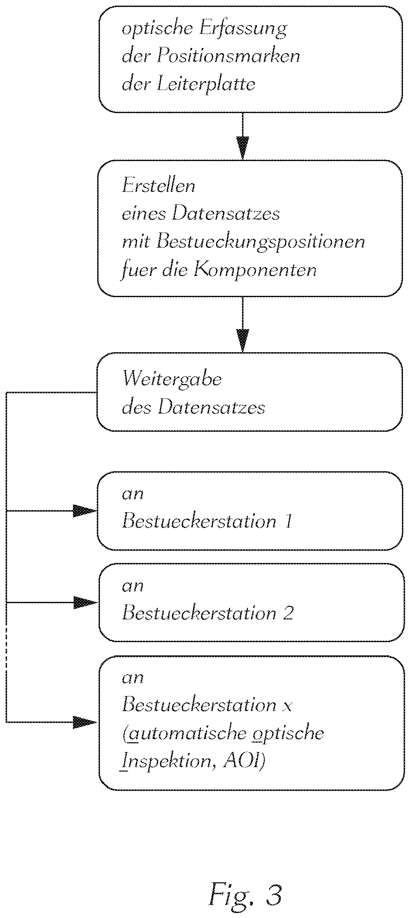

In Fig. 3 ist nochmals der gesamte Verfahrensablauf im Überblick dargestellt. Zur Positionierung der elektronischen Komponenten bzw. der LEDs oder Laserdioden erfolgt eine optische Erfassung der Positionsmarken der Leiterplatte, wobei diese Positionsmarken erfindungsgemäß Ausrichtmarken der Leiterplatte sind, die für das Zusammenwirken mit mechanischen Positionierungsmitteln des Fahrzeugscheinwerfers vorgesehen sind. Aus der Lage beziehungsweise den Positionsdaten der zumindest einen Ausrichtmarke wird ein Datensatz mit einer Bestückungsposition für die Komponente erstellt und der Datensatz wird an eine Bestückungsmaschine weitergegeben bzw. dieser zur Verfügung gestellt. Eine Bestückungsmaschine kann eine Vielzahl von Bestückerstationen umfassen. Am Ende des Verfahrens erfolgt eine Ausgangskontrolle in Form von automatischer optischer Inspektion (AOI).

## Patentansprüche

1. Verfahren zur Positionierung zumindest einer elektronischen Komponente (3) auf einer zum Einbau in einen Fahrzeugscheinwerfer vorgesehenen Leiterplatte (1), wobei die Leiterplatte (1) zumindest eine Positionsmarke umfasst und die Positionierung der zumindest einen elektronischen Komponente (3) relativ zu der zumindest einen Positionsmarke auf der Leiterplatte (1) erfolgt, wobei die zumindest eine Positionsmarke optisch erfasst und zum Positionieren herangezogen wird, wobei die als zumindest eine Positionsmarke zumindest eine Ausrichtmarke (5, 6, 7, 8, 8', 8") der Leiterplatte (1) verwendet wird, welche in dem Fahrzeugscheinwerfer im eingebauten Zustand der Leiterplatte (1) mit einem zur Ausrichtmarke (5, 6, 7, 8, 8', 8") komplementären Positionierungsmittel (9, 15) des Fahrzeugscheinwerfers mechanisch zusammenwirkt,
**dadurch gekennzeichnet, dass** die zumindest eine Ausrichtmarke (5, 6, 7, 8, 8', 8") von einer ersten Seite der Leiterplatte (1) insbesondere mit einer Kamera (12) optisch erfasst wird und die Leiterplatte (1) von einer zweiten, der ersten Seite gegenüberliegenden Seite beleuchtet wird.

2. Verfahren nach Anspruch 1, **dadurch gekennzeichnet, dass** zumindest zwei Ausrichtmarken (5, 6, 7, 8, 8', 8") der Leiterplatte (1) zur Positionierung der zumindest einen elektronischen Komponente (3) herangezogen werden.

3. Verfahren nach Anspruch 2, **dadurch gekennzeichnet, dass** die zumindest zwei Ausrichtmarken (5, 6, 7, 8, 8', 8") an gegenüberliegenden Rändern der Leiterplatte (1) gelegen sind.

4. Verfahren nach einem der Ansprüche 1 bis 3, **dadurch gekennzeichnet, dass** die Leiterplatte (1) im Wesentlichen eine rechteckige Form mit kurzen und langen Rändern aufweist und die zumindest zwei Ausrichtmarken (5, 6, 7, 8, 8', 8") an den langen, gegenüberliegenden Rändern der Leiterplatte (1) gelegen sind.

5. Verfahren nach einem der Ansprüche 1 bis 4, **dadurch gekennzeichnet, dass** anhand von Positionsdaten der zumindest einen Ausrichtmarke (5, 6, 7, 8, 8', 8") ein Datensatz mit einer Bestückungsposition für die zumindest eine Komponente (3) erstellt und einer Bestückungsmaschine für elektronische Komponenten (3) zur Verfügung gestellt wird.

6. Verfahren nach Anspruch 1, **dadurch gekennzeichnet, dass** das Beleuchten mit parallelgerichtetem Licht (13) erfolgt.

7. Verfahren nach einem der Ansprüche 1 bis 6, **dadurch gekennzeichnet, dass** eine Mehrzahl von Positionsmarken einer Leiterplatte (1) erfasst wird.

8. Verfahren nach einem der Ansprüche 1 bis 7, **dadurch gekennzeichnet, dass** mehrere Leiterplatten (1) auf einem gemeinsamen Nutzen hergestellt werden und das Erfassen der zumindest einen Positionsmarke erfolgt, wenn die Leiterplatten (1) noch nicht voneinander getrennt sind.

9. Verfahren nach Anspruch 8, **dadurch gekennzeichnet, dass** jeweils zumindest eine Positionsmarke für jeweils eine Leiterplatte (1) auf dem gemeinsamen Nutzen erfasst wird.

10. Verfahren nach Anspruch 9, **dadurch gekennzeichnet, dass** eine Mehrzahl von Positionsmarken für eine zu positionierende Komponente (3) für jeweils eine Leiterplatte auf dem gemeinsamen Nutzen erfasst und zur Erstellung eines Datensatzes mit einer Bestückungsposition für die Komponente (3) herangezogen wird.

11. Verfahren nach einem der Ansprüche 1 bis 10, **dadurch gekennzeichnet, dass** mehrere Leiterplatten (1) auf einem gemeinsamen Nutzen hergestellt werden und die zumindest eine Ausrichtmarke (6, 7, 8, 8', 8") erst nach einer Vereinzelung der Leiterplatte (1) aus dem gemeinsamen Nutzen an einem Rand der Leiterplatte (1) gelegen ist.

12. Verfahren nach einem der Ansprüche 1 bis 11, **dadurch gekennzeichnet, dass** die elektronische Komponente (3) ausgewählt ist aus der Gruppe bestehend aus einer SMD-Komponente, einer LED, einer Laserdiode und einer Photodiode.

13. Verfahren nach einem der Ansprüche 1 bis 12, **dadurch gekennzeichnet, dass** die erste Seite der Leiterplatte (1) jene Seite der Leiterplatte ist, auf der die zumindest eine elektronische Komponente (3) positioniert wird.

## Claims

1. Method for positioning at least one electronic component (3) on a printed circuit board (1) provided for installation in a vehicle headlamp, the printed circuit board (1) comprising at least one position mark and the positioning of the at least one electronic component (3) taking place relative to the at least one position mark on the printed circuit board (1), the at least one position mark being optically detected and used for positioning, the at least one alignment mark (5, 6, 7, 8, 8', 8") of the printed circuit board (1) being used as the at least one position mark, which alignment mark interacts mechanically in the vehicle headlight in the installed state of the printed circuit board (1) with a positioning means (9, 15) of the vehicle headlight which is complementary to the alignment mark (5, 6, 7, 8, 8', 8"),
**characterized in that** the at least one alignment mark (5, 6, 7, 8, 8', 8") is optically detected from a first side of the printed circuit board (1), in particular by a camera (12), and the printed circuit board (1) is illuminated from a second side opposite the first side.

2. Method according to claim 1, **characterized in that** at least two alignment marks (5, 6, 7, 8, 8', 8") of the printed circuit board (1) are used for positioning the at least one electronic component (3).

3. Method according to claim 2, **characterized in that** the at least two alignment marks (5, 6, 7, 8, 8', 8") are located on opposite edges of the printed circuit board (1).

4. Method according to one of claims 1 to 3, **characterized in that** the printed circuit board (1) has a substantially rectangular shape with short and long edges and the at least two alignment marks (5, 6, 7, 8, 8', 8") are located on the long, opposite edges of the printed circuit board (1).

5. Method according to one of claims 1 to 4, **characterized in that** a data record with a placement position for the at least one component (3) is created on the basis of position data of the at least one alignment mark (5, 6, 7, 8, 8', 8") and is made available to a placement machine for electronic components (3).

6. Method according to claim 1, **characterized in that** the illumination is performed with parallel-directed light (13).

7. Method according to any one of claims 1 to 6, **characterized in that** a plurality of position marks of a printed circuit board (1) are detected.

8. Method according to one of the claims 1 to 7, **characterized in that** several printed circuit boards (1) are produced on a common use and the detection of the at least one position mark takes place when the printed circuit boards (1) are not yet separated from one another.

9. Method according to claim 8, **characterized in that** in each case at least one position mark is detected for in each case one printed circuit board (1) on the common panel.

10. Method according to claim 9, **characterized in that** a plurality of position marks for a component (3) to be positioned is detected for a respective printed circuit board on the common panel and is used to create a data record with a component position for the component (3).

11. Method according to one of the claims 1 to 10, **characterized in that** several printed circuit boards (1) are produced on a common panel and the at least one alignment mark (6, 7, 8, 8', 8") is located on an edge of the printed circuit board (1) only after the printed circuit board (1) has been separated from the common panel.

12. Method according to any one of claims 1 to 11, **characterized in that** the electronic component (3) is selected from the group consisting of an SMD component, an LED, a laser diode and a photodiode.

13. Method according to any one of claims 1 to 12, **characterized in that** the first side of the printed circuit board (1) is that side of the printed circuit board on which the at least one electronic component (3) is positioned.

## Revendications

1. Procédé de positionnement d'au moins un composant électronique (3) sur une carte de circuit imprimé (1) prévue pour être montée dans un phare de véhicule, la carte de circuit imprimé (1) comprenant au moins un repère de position et le positionnement du au moins un composant électronique (3) s'effectuant par rapport au au moins un repère de position sur la carte de circuit imprimé (1), l'au moins un repère de position étant détecté optiquement et utilisé pour le positionnement, l'au moins un repère d'alignement (5, 6, 7, 8, 8', 8") de la carte de circuit imprimé (1) étant utilisé comme au moins un repère de position, lequel coopère mécaniquement avec un moyen de positionnement (9, 15) du projecteur de véhicule complémentaire au repère d'alignement (5, 6, 7, 8, 8', 8") à l'état monté de la carte de circuit imprimé (1),
**caractérisé en ce que** ledit au moins un repère d'alignement (5, 6, 7, 8, 8', 8") est détecté optiquement par une première face de la carte de circuit imprimé (1), notamment par une caméra (12), et la carte de circuit imprimé (1) est éclairée par une deuxième face opposée à la première face.

2. Procédé selon la revendication 1, **caractérisé en ce qu'**au moins deux repères d'alignement (5, 6, 7, 8, 8', 8") de la carte de circuit imprimé (1) sont utilisés pour positionner ledit au moins un composant électronique (3).

3. Procédé selon la revendication 2, **caractérisé en ce que** les au moins deux repères d'alignement (5, 6, 7, 8, 8', 8") sont situés sur des bords opposés du circuit imprimé (1).

4. Procédé selon l'une quelconque des revendications 1 à 3, **caractérisé en ce que** la carte de circuit imprimé (1) a une forme sensiblement rectangulaire avec des bords courts et des bords longs, et les au moins deux marques d'alignement (5, 6, 7, 8, 8', 8") sont situées sur les bords longs opposés de la carte de circuit imprimé (1).

5. Procédé selon l'une des revendications 1 à 4, **caractérisé en ce que**, à l'aide de données de position de l'au moins un repère d'alignement (5, 6, 7, 8, 8', 8"), un jeu de données avec une position de montage pour l'au moins un composant (3) est créé et mis à la disposition d'une machine de montage de composants électroniques (3).

6. Procédé selon la revendication 1, **caractérisé en ce que** l'éclairage est réalisé avec une lumière parallélisée (13).

7. Procédé selon l'une des revendications 1 à 6, **caractérisé en ce qu'**une pluralité de marques de position d'une carte de circuit imprimé (1) est détectée.

8. Procédé selon l'une des revendications 1 à 7, **caractérisé en ce que** plusieurs cartes de circuits imprimés (1) sont fabriquées sur un support commun et **en ce que** la détection d'au moins une marque de position a lieu lorsque les cartes de circuits imprimés (1) ne sont pas encore séparées les unes des autres.

9. Procédé selon la revendication 8, **caractérisé en ce qu'**au moins une marque de position est détectée pour chaque carte de circuit imprimé (1) sur l'utilité commune.

10. Procédé selon la revendication 9, **caractérisé en ce qu'**une pluralité de marques de position pour un composant (3) à positionner est saisie pour une carte de circuit imprimé respective sur l'utilité commune et est utilisée pour créer un jeu de données avec une position de pièce pour le composant (3).

11. Procédé selon l'une des revendications 1 à 10, **caractérisé en ce que** plusieurs cartes de circuits imprimés (1) sont fabriquées sur une utilité commune et **en ce qu'**au moins une marque d'alignement (6, 7, 8, 8', 8") n'est située sur un bord de la carte de circuits imprimés (1) qu'après une séparation de la carte de circuits imprimés (1) de l'utilité commune.

12. Procédé selon l'une des revendications 1 à 11, **caractérisé en ce que** le composant électronique (3) est choisi dans le groupe constitué par un composant SMD, une LED, une diode laser et une photodiode.

13. Procédé selon l'une quelconque des revendications 1 à 12, **caractérisé en ce que** le premier côté de la carte de circuit imprimé (1) est le côté de la carte de circuit imprimé sur lequel le au moins un composant électronique (3) est positionné.
